# FASCICULE DE BREVET EUROPEEN

(11) **EP 3 910 344 B1**
(45) Date de publication et mention de la délivrance du brevet: **08.11.2023**
(21) Numéro de dépôt: 21173188.0
(22) Date de dépôt: 11.05.2021
(51) Int. Cl.: G01P 15/12, G01C 19/5733, B81B 3/00, G01L 1/18

(54) **DISPOSITIF DE DÉTECTION UTILISANT UN TRANSDUCTEUR PIÉZORÉSISTIF**
DETEKTIONSVORRICHTUNG MIT PIEZORESISTIVEM WANDLER
DETECTION DEVICE USING PIEZORESISTIVE TRANSDUCER

(30) Priorité: 14.05.2020 FR 2004767
(43) Date de publication de la demande: 17.11.2021
(73) Titulaire: Commissariat à l'Energie Atomique et aux Energies Alternatives, 75015 Paris (FR)
(72) Inventeur: NOWODZINSKI, Antoine, 38054 GRENOBLE (FR)
(74) Mandataire: Hautier IP

(56) Documents cités:
- US-A1- 2006 060 003
- PH. ROBERT ET AL: "M&NEMS: A new approach for ultra-low cost 3D inertial sensor", 2009 IEEE SENSORS, 1 octobre 2009 (2009-10-01), pages 963-966, XP055023740, DOI: 10.1109/ICSENS.2009.5398195 ISBN: 978-1-42-444548-6
- NOWODZINSKI ANTOINE ET AL: "1/f Noise Characterization of Piezoresistive Nano-Gauges for MEMS Sensors", 2018 IEEE SENSORS, IEEE, 28 octobre 2018 (2018-10-28), pages 1-4, XP033477600, DOI: 10.1109/ICSENS.2018.8589872
- HARKEY J A ET AL: "1/f noise considerations for the design and process optimization of piezoresistive cantilevers", JOURNAL OF MICROELECTROMECHANICAL SYSTEMS, IEEE SERVICE CENTER, US, vol. 9, no. 2, 1 juin 2000 (2000-06-01), pages 226-235, XP011450837, ISSN: 1057-7157, DOI: 10.1109/84.846703
- YU XIAOMEI ET AL: "Optimization of sensitivity and noise in piezoresistive cantilevers", JOURNAL OF APPLIED PHYSICS, AMERICAN INSTITUTE OF PHYSICS, US, vol. 92, no. 10, 15 novembre 2002 (2002-11-15), pages 6296-6301, XP012056627, ISSN: 0021-8979, DOI: 10.1063/1.1493660

## Description

### DOMAINE TECHNIQUE

La présente invention concerne le domaine des dispositifs de détection piézorésisitifs.

De manière générale, ce type de dispositif fait appel à la capacité de transduction de matériaux piézorésistifs. Il peut s'agir de capteurs inertiels de type accéléromètre, gyroscope ou gyromètre à un axe ou multiaxes, ou encore des capteurs de pression, des magnétomètres ou des microphones. Cela concerne les capteurs sous forme de dispositifs micro-électroniques. Par dispositif micro-électronique, on entend tout type de dispositif réalisé avec les moyens de la microélectronique. Ces dispositifs englobent des dispositifs micromécaniques ou électromécaniques (MEMS, NEMS...).

### ÉTAT DE LA TECHNIQUE

Les nanojauges piézorésistives sont utilisées dans de nombreux capteurs MEMS comme transducteurs entre une grandeur mécanique à mesurer (pression, accélération, rotation, ...) et une grandeur électrique utilisable en électronique (tension, courant ou résistance). Ce type de transduction utilise la piézorésistivité d'une jauge pour convertir une contrainte mécanique en variation de résistance électrique.

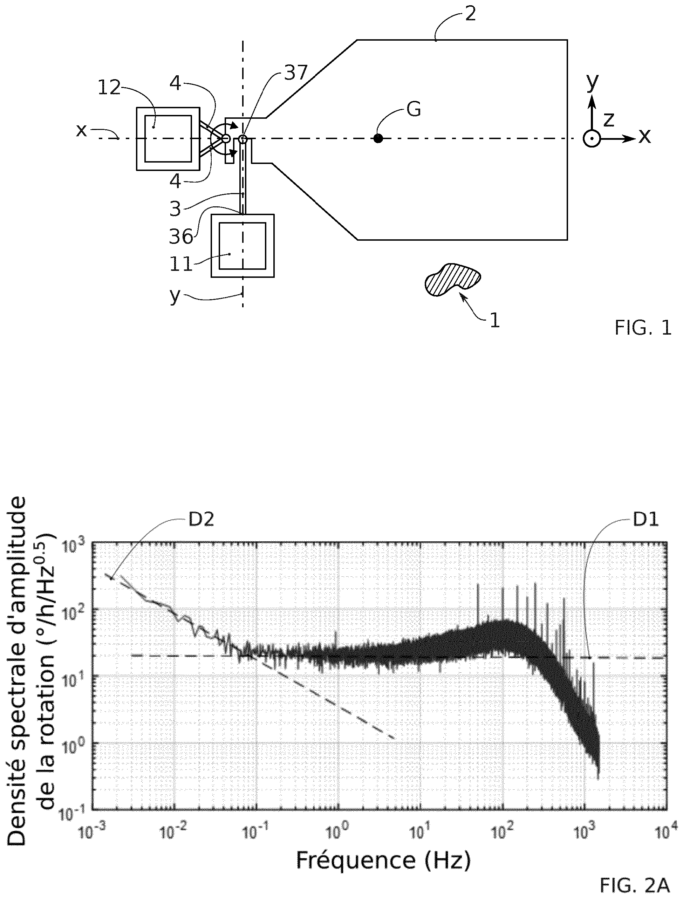

La figure 1 présente un exemple de dispositif de détection connu, ici un accéléromètre (mais on pourrait aussi prendre en exemple un gyromètre de manière similaire), dans lequel une masse 2, ayant un centre de gravité G, est montée mobile relativement à un substrat, par exemple à base de silicium. Dans le cas d'espèce, on cherche à mesurer un déplacement de la masse mobile 2 en rotation dans le plan XY du repère orthogonal XYZ représenté, c'est-à-dire une rotation autour d'un axe suivant la direction Z, comme l'indique la portion de flèche circulaire sur la figure 1. Dans cet exemple, la masse 2 est mobile suivant cette direction de rotation grâce à des charnières 4 qui relient, avec une liberté de mouvement en rotation selon Z, la masse 2 à une zone d'ancrage 12 intégrée au substrat.

Le mouvement de rotation peut être traduit en une valeur électrique par l'intermédiaire d'une jauge de contrainte 3 utilisant la capacité d'un matériau piézorésistif de convertir une grandeur mécanique en une grandeur électrique, et, de manière primaire, en variation de résistance électrique. Dans le cas représenté, la jauge 3 présente la forme d'une poutre dont une première extrémité 36 est ancrée sur une zone d'encastrement 11 intégrée au substrat 1 et dont l'autre extrémité 37 est ancrée sur la masse mobile 2. La poutre de la jauge 3 présente une dimension en longueur dirigée suivant la direction Y.

On comprend qu'un mouvement de la masse 2 dans le plan XY va produire une déformation de la jauge 3, ici essentiellement en traction/compression, ce qui va induire une variation de résistance électrique du matériau piézorésistif de la jauge 3, variation de résistance électrique qui peut être mesurée par un circuit de mesure. Ce dernier peut par exemple détecter une variation du rapport entre le courant circulant dans la jauge et la tension entre la jauge et le substrat au cours du temps, de sorte à évaluer la variation de résistance.

Le rapport signal à bruit du capteur final dépend en partie des performances de la transduction. Pour les nanojauges, le signal maximal pouvant être converti en variation de résistance est limité par la limite élastique des nanojauges tandis que le bruit du capteur est pénalisé par le bruit des nanojauges.

Deux types de bruits dominent ce type de transducteurs à jauge piézorésistive.

Le premier type correspond au bruit Johnson, ou encore bruit blanc, le plus souvent d'origine thermique, de densité spectrale d'amplitude constante.

Le bruit Flickers correspond au deuxième type de bruit, et sa densité spectrale d'amplitude est du type A.f^{-α}, f étant la fréquence, A étant la densité spectrale de bruit à 1 Hz et α étant une constante comprise entre 0,4 et 0,6 (lorsque le bruit est exprimé en densité spectrale d'amplitude). Ce bruit est donc du type en 1/f, ce qui le rend d'autant plus pénalisant dans les basses fréquences, en particulier pour des acquisitions longues.

L'impact de ces deux types de bruit sur la résolution du capteur est fort différent, et est analysable dans le domaine temporel en fonction de la durée d'intégration, par l'écart type d'Allan. La résolution maximale d'un capteur sera donnée par le minimum de l'écart type (ou de la variance) d'Allan et celle-ci est directement limitée par le deuxième type de bruit.

La figure 2A traduit une évolution de la densité spectrale d'amplitude du bruit d'un gyromètre à jauge piézorésistive. Sur cette courbe, on note un niveau constant de bruit blanc, correspondant au niveau de la ligne D1, dans le cas d'espèce à 20°/h/Hz^{0.5}. Le deuxième type de bruit, en 1/f, correspond à la direction D2 et ressort à une valeur de 3°/h/Hz^{0.5}, à une fréquence de 1 Hz.

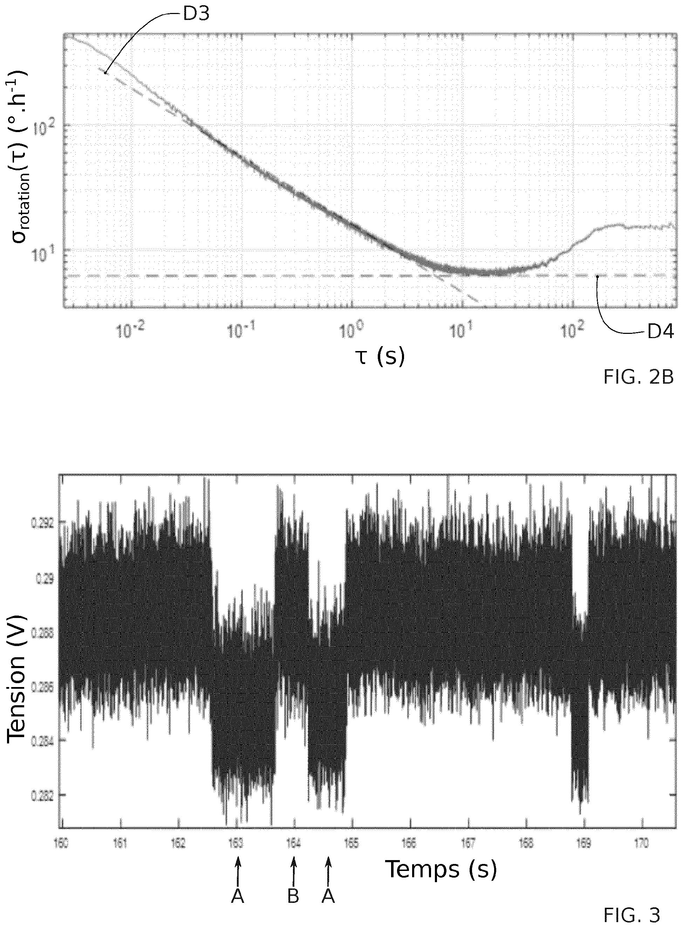

La figure 2B montre quant à elle l'évolution de l'écart type d'Allan en fonction du temps d'intégration. Pour des temps d'intégration relativement faibles, le bruit blanc prédomine, comme le révèle la pente D3, l'écart type d'Allan décroissant de manière linéaire, avec une pente de l'ordre de -0,5, avec le temps d'intégration. La courbe adopte un comportement bien différent ensuite, révélant l'influence du bruit en 1/f pour des temps d'intégration plus longs, par exemple au-delà d'une seconde.

La publication scientifique Ph. ROBERT et Al « M&NEMS : A new approach for ultra-low cost 3D inertial sensor »2009 IEEE SENSORS, du 1er octobre 2009, pages 963-966, XP055023740, présente un capteur inertiel doté d'une poutre piézoélectrique. La réduction du bruit est un problème dans ce type de capteur.

Il existe donc un besoin pour proposer des dispositifs de détection au fonctionnement piézorésistif qui propose une réduction du bruit, et notamment du bruit en 1/f, qui est particulièrement pénalisant en basse fréquence.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un mode de réalisation on prévoit un dispositif de détection à transduction selon la revendication 1, comprenant un substrat et une jauge de contrainte suspendue au-dessus d'une face du substrat et comprenant un élément piézorésistif. La jauge comprend de manière avantageuse une première extrémité ancrée relativement au substrat et une deuxième extrémité ancrée relativement à une masse mobile relativement au substrat.

De manière avantageuse, au moins une partie de la surface de l'élément piézorésistif est recouverte par un empilement comprenant, successivement depuis la surface de l'élément piézorésistif, une couche diélectrique et une couche électriquement conductrice.

On forme ainsi, avec le matériau piézorésistif, un ensemble capacitif dont la capacité vient s'ajouter à, ou remplacer, celle produite entre ledit matériau et le substrat, avec comme entrefer pour le moins une couche d'air et éventuellement d'autres couches isolantes, comme une couche d'oxyde à la surface du substrat. La capacité additionnelle créée a pour effet d'accroitre la capacité totale entre le substrat et la jauge suspendue.

Le demandeur a en effet constaté que l'accroissement de la capacité globale permet de limiter l'influence des phénomènes d'absorption et de relaxation de charges dans le matériau piézorésistif de la jauge. Comme décrit plus loin, ces phénomènes engendrent des sauts de tension au niveau de la jauge qui sont synonymes de bruits à chaque occurrence.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente un exemple de structure connue d'un dispositif de détection sous forme d'un accéléromètre.
La figure 2A représente l'évolution de la densité spectrale d'amplitude du bruit d'un gyromètre, en °/h/Hz^{0.5}, en fonction de la fréquence en Hz.
La figure 2B représente l'évolution de l'écart type d'Allan, exprimée en °.h⁻¹, en fonction du temps d'intégration exprimée en secondes, pour le gyromètre de la figure 2A.
La figure 3 illustre le phénomène de bruits télégraphiques qui peut être provoqué par des pièges à la surface du matériau piézorésistif, conduisant à des phénomènes d'absorption et de relaxation de porteurs de charge.
La figure 4 schématise l'effet capacitif existant entre une jauge et le substrat au-dessus duquel la jauge suspendue.
Les figures 5A et 5B représentent respectivement un premier mode de réalisation de l'invention et une schématisation des capacités électriques induites par ce mode de réalisation.
Les figures 6A et 6B représentent respectivement un deuxième mode de réalisation de l'invention et une schématisation des capacités électriques induites par ce mode de réalisation.
Les figures 7A et 7B représentent respectivement un troisième mode de réalisation de l'invention et une schématisation des capacités électriques induites par ce mode de réalisation.
La figure 8 reflète une modélisation de l'effet de l'invention sur la densité spectrale de bruit, dans le cas d'espèce pour un accéléromètre.
La figure 9 montre une modélisation de l'effet de l'invention sur l'écart type d'Allan de ce même accéléromètre.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
- Selon un exemple, la capacité électrique formée par l'élément piézorésisitif et l'empilement est d'une valeur supérieure à celle d'un condensateur formé entre l'élément piézorésisitif et le substrat. D'une manière générale, lorsque l'empilement conduit à former une ou plusieurs capacités fonctionnant en parallèle de la capacité habituelle de l'élément résistif avec le substrat, la capacité globale est toujours augmentée. Dans ce cas, il reste intéressant que la valeur capacitive additionnelle fournie par l'empilement soit importante, et de préférence supérieure à la capacité habituelle de l'élément résistif avec le substrat, de sorte à ce que la capacité globale soit élevée. Dans le cas où l'empilement est tel que la capacité habituelle entre l'élément résistif et le substrat n'existe plus, typiquement lorsque l'empilement recouvre la face inférieure de l'élément résistif, il est souhaitable que la capacité globale produite par l'empilement soit supérieure à celle qui aurait existé sans sa présence. Ainsi, on augmente dans tous les cas la valeur de la capacité électrique relativement au substrat.
- Suivant une possibilité, la partie recouverte comprend une portion de surface de l'élément piézorésistif opposée à la face du substrat ; cette situation est favorable à la facilité de fabrication, dans la mesure où l'empilement peut être formé à ce niveau de manière simple, la face opposée en question étant exposée vers l'extérieur, ce qui peut faciliter la phase de dépôt de couches.
- Suivant une autre possibilité, la partie recouverte comprend une portion de surface de l'élément piézorésistif en regard de la face du substrat ; cette option permet de remplacer la capacité habituelle entre l'élément résistif et le substrat.
- Selon un exemple, l'élément piézorésisif est une poutre ; sa structure géométrique peut faciliter la formation de l'empilement. La poutre pourra comprendre une section de type rectangulaire, voire carrée, apte à créer des côtés qui peuvent être en tout ou partie recouverts par l'empilement ; il est entendu que le dispositif peut comprendre une pluralité de jauges qui peuvent chacune comprendre au moins une poutre piézorésistive.
- Éventuellement, la poutre s'étend sur toute la longueur de la jauge, entre ses première et deuxième extrémités ; d'une manière générale, l'élément résistif est de préférence étendu suivant toute la dimension de la jauge.
- Suivant une possibilité, la partie recouverte s'étend suivant la totalité d'une dimension en longueur de l'élément piézorésistif ; ce cas est favorable à l'accroissement de la capacité, qui est directement proportionnelle à l'accroissement de la surface de l'empilement.
- Dans un mode de réalisation, la couche diélectrique est en un matériau à base d'oxyde ou de nitrure de silicium.
- La couche électriquement conductrice peut quant à elle être à base de silicium dopé ou d'un métal.
- Dans un mode de réalisation, la jauge comprend une première extrémité ancrée relativement au substrat ; cet ancrage peut être réalisé lors de la constitution de l'élément piézorésistif qui dispose alors d'une extrémité ancrée dans le substrat.
- Selon un exemple, la jauge comprend une deuxième extrémité ancrée relativement à une masse mobile relativement au substrat ; cette disposition est particulièrement applicable dans le cas d'une jauge sous forme de poutre ; comme pour l'autre extrémité, l'ancrage peut être réalisé par une extrémité de l'élément piézorésistif.

Il est précisé que, dans le cadre de la présente invention, le terme « sur» ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant, soit directement à son contact, soit en étant séparée d'elle par un film, ou encore une autre couche ou un autre élément. En particulier, la jauge de contrainte est suspendue au-dessus d'une face du substrat, ce qui implique un espace, généralement empli d'air, intermédiaire entre ladite jauge et cette face du substrat. Une couche peut par ailleurs être composée de plusieurs sous-couches d'un même matériau ou de matériaux différents.

Il est précisé que dans le cadre de la présente invention, l'épaisseur d'une couche ou du substrat se mesure selon une direction perpendiculaire à la surface selon laquelle cette couche ou ce substrat présente son extension maximale. Si une couche n'est pas totalement plane, notamment parce qu'elle présente des défauts qui sont susceptibles d'être en relief sur la face exposée de ladite couche, l'épaisseur s'entend de la dimension de cette couche en dehors de ses défauts.

Certaines parties du dispositif de l'invention peuvent avoir une fonction électrique. Certaines sont employées pour des propriétés de conduction électrique et on entend comme ayant une nature électriquement conductrice, des éléments formés d'au moins un matériau ayant une conductivité électrique suffisante, dans l'application, pour réaliser la fonction souhaitée ; c'est en particulier le cas pour une couche servant à former une partie ou armature conductrice d'un condensateur. À l'inverse, on entend par isolant électrique ou diélectrique un matériau qui, dans l'application, assure une fonction d'isolation électrique ; c'est en particulier le cas pour une couche servant à former un isolant intermédiaire ou entrefer d'un condensateur.

On entend par un substrat, un élément, une couche ou autre « à base » d'un matériau M, un substrat, un élément, une couche comprenant ce matériau M uniquement ou ce matériau M et éventuellement d'autres matériaux, par exemple des éléments d'alliage, des impuretés ou des éléments dopants. Le cas échéant, le matériau M peut présenter différentes stoechiométries.

La figure 3 reflète le bruit télégraphique dans une nano jauge de nature piézorésistive présentant, pour l'exemple uniquement, une dimension de 2x0.25x0.25 micromètres, en silicium dopé. On y remarque que la tension de la jauge, donnée en ordonnée, connaît des sauts reflétés par les baisses de tension dans les phases repérées A relativement au niveau de tension repéré B, au cours du temps donné en abscisse. Dans cet exemple, le saut peut correspondre à une descente de tension de 4 mV. Cette variation est due à l'absorption d'une charge par un piège à la surface du silicium absorbant, par effet tunnel, les porteurs de charge circulant. Lorsque le nombre de pièges est faible, la signature de ce type de bruit est du type télégraphique, comme le montre la figure 3, car les absorptions et les relaxations s'enchaînent de manière individuelle. Par contre, si la densité des pièges augmente, il n'est plus possible de distinguer les variations d'états liées aux absorptions et/ou relaxations, et la densité spectrale de bruit est alors en 1/f.

D'une manière générale, les niveaux de variation de tension ΔV constatés dans ce phénomène d'absorption et de relaxation de charges par un piège sont inversement proportionnels à la capacité électrique C formée entre la jauge et le substrat. En effet, la variation de tension est du type ΔV=q/C, où q reflète la charge électrique. Typiquement, pour une jauge correspondant au bruit télégraphique de la figure 3, réalisée en silicium, suspendue au-dessus d'un substrat lui-même en silicium, à une distance de 2 µm, la capacité électrique peut correspondre à une valeur de l'ordre de 30 à 40 aF (aF pour 10⁻¹⁸ Farads).

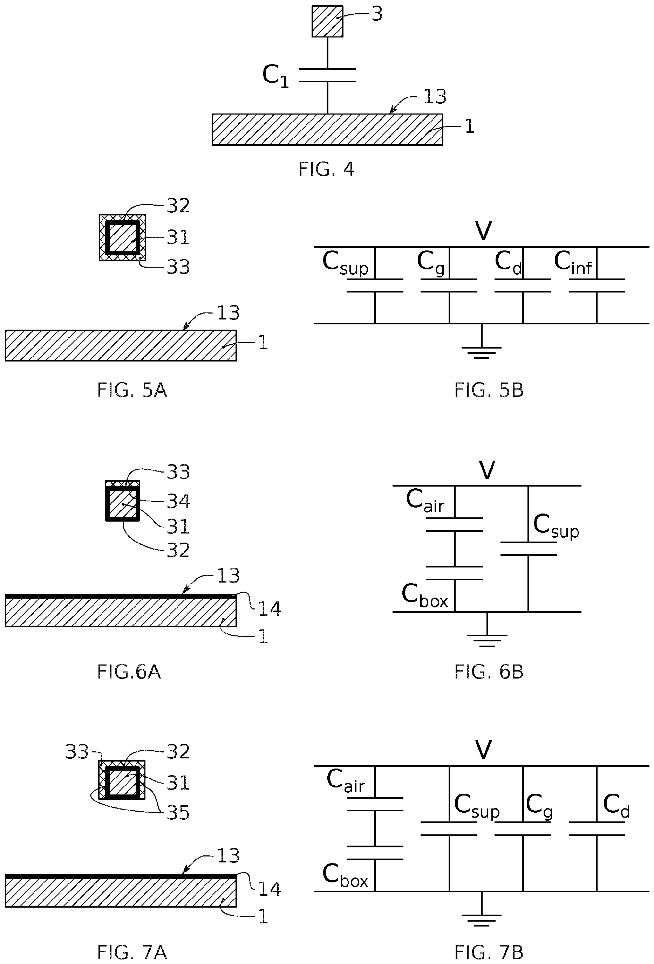

La figure 4 schématise la production de cet effet capacitif de valeur C1 de par la suspension de la jauge 3 au-dessus d'une face 13 d'un substrat 1. Dans cet exemple simple, la jauge peut par exemple être en silicium dopé et la face du substrat correspondre également à un matériau semi-conducteur de type silicium. L'isolant intermédiaire de ces deux parties conductrices est alors formé par une couche d'air.

Au regard de ce constat, il est ici proposé d'augmenter la capacité électrique de la jauge 3 relativement au substrat 1, de sorte à réduire l'influence des phénomènes liés au piège de charges dans la jauge 3.

D'une manière générale, la jauge 3 est améliorée par la constitution d'au moins un élément condensateur supplémentaire, de sorte que la capacité globale relativement au substrat est augmentée.

La figure 5A fournit un premier exemple de structure de jauge dans un mode de réalisation de l'invention. Cette illustration correspond typiquement à une coupe suivant une section transversale à l'axe longitudinal de la jauge 3, ce qui correspond à une section suivant perpendiculaire à la direction Y présentée à la figure 1. Hormis pour la présence de l'empilement détaillé ci-après, la description donnée de la figure 1 est applicable à la réalisation de l'invention.

La jauge 3 présente d'abord un élément piézorésistif 31. Ce dernier peut notamment être réalisé à partir de quartz ou, plus communément, de silicium, préférentiellement dopé afin de diminuer sa résistivité. Cet élément piézorésistif 31 peut être conforme à une jauge piézorésistive classique.

Comme dans le cas de la jauge 3 de l'état la technique présentée à la figure 1, l'élément piézorésistif 31 peut ainsi s'étendre intégralement entre deux extrémités 36,37 d'ancrage. La section carrée représentée à la figure 5A n'est pas limitative ; notamment, d'autre sections polygonales, et en particulier rectangulaire, sont possibles.

Dans un mode de réalisation, l'élément 31 est une poutre, de préférence de section transversale rectangulaire, dont la dimension longue est dirigée suivant la direction Y de la figure 1.Une section circulaire est aussi envisageable. Néanmoins, d'autres formes géométriques sont possibles, notamment une membrane.

L'élément résistif 31 surplombe une face 13 du substrat 1. Ce dernier peut être fait de silicium, éventuellement avec une couche superficielle d'oxyde, natif ou non, définissant la surface 13.

Dans un mode de réalisation, la mise en suspension de l'élément 31 piézorésistif est produite de la façon suivante : l'élément 31 est défini à la surface du substrat, par exemple dans une couche de silicium monocristallin (par exemple la couche supérieure d'un substrat du type silicium sur isolant) ; puis la couche sous-jacente (par exemple le matériau isolant d'un substrat du type silicium sur isolant), est attaquée par gravure pour produire la libération de l'élément 31. Cette gravure est limitée latéralement de sorte à préserver au moins un ancrage de l'élément 31 relativement au substrat 1. La face 13 du substrat 20 peut être formée par la surface d'une portion résiduelle de la couche ayant fait l'objet de l'attaque par gravure, typiquement un matériau isolant, comme de l'oxyde de silicium. Elle peut aussi être formée par la surface d'une couche initialement située sous la couche d'isolant ou encore par la surface d'une couche rapportée ensuite, ou encore par la surface d'une couche d'oxyde formée naturellement après la libération de l'élément 31.

De manière caractéristique, l'élément piézorésistif 31 ainsi suspendu est recouvert par un empilement comportant successivement une couche diélectrique 32 et une couche électriquement conductrice 33. Cette couverture n'est pas obligatoirement complète, sur l'intégralité de la surface extérieure de l'élément résistif 31. Cependant, de préférence, cette couverture s'étend continûment sur toute la longueur de l'élément résistif 31. Dans le cas préféré où l'élément piézorésistif 31 dispose d'une section polygonale, la couverture s'étend donc préférentiellement sur l'ensemble d'au moins un des côtés de cette section.

Dans le cas de la figure 5A, en section transversale, l'empilement formé par les couches 32,33 couvrent l'intégralité du pourtour de l'élément résistif 31, formant un contour fermé autour de ce dernier. Ainsi, une portion supérieure de l'empilement conduit à former un condensateur supérieur avec l'élément résistif 31, une portion inférieure de l'empilement conduit à former un condensateur inférieur avec l'élément résistif 31 et deux portions latérales de l'empilement conduisent à former de condensateurs latéraux avec l'élément résistif 31, à gauche et à droite de ce dernier.

Dans ce contexte, comme le révèle la figure 5B, la structure de la jauge 3 de la figure 5A induit la mise en parallèle d'une pluralité de condensateurs présentant chacun une valeur capacitive. Plus particulièrement, se trouve associées : une capacité Csup correspondant au condensateur supérieur, une capacité Cinf correspondant au condensateur inférieur, une capacité Cg correspondant au condensateur gauche et une capacité Cd correspondant au condensateur droit. Cette association conduit un accroissement significatif de la valeur de capacité séparant la jauge du substrat.

La figure 6A représente une variante de réalisation. De façon accessoire, on y a représenté que la face 13 du substrat 20 peut être formée par la surface d'une couche isolante superficielle 14, étant rappelé que cette possibilité était aussi valable dans le cas précédent.

Par contre, un seul condensateur est produit par l'empilement des couches 31,32 dans ce cas de figure. En effet, dans cet exemple, la couche diélectrique 32 parcourt toujours l'ensemble du contour de l'élément résistif 31. Cependant, la couche électriquement conductrice 33 ne surmonte ici que la face 34 de l'élément piézorésistif 31, opposée au substrat 1. Dans un mode de réalisation non représenté, la couche diélectrique 32 ne recouvre que la face 34 de l'élément piézorésistif 31.

Dans le contexte structurel de la figure 6A, l'effet capacitif produit entre la jauge 3 et le substrat 1 correspond au schéma de la figure 6B : sont associés en parallèle un condensateur correspondant au condensateur supérieur produit par l'élément piézorésistif 31, la couche 32 et la couche 33, et un condensateur correspondant à la situation habituelle, précédemment schématisée la figure 4, mettant ici en oeuvre un isolant intermédiaire sous forme d'une couche d'air et une couche d'oxyde, et schématisée par les capacités Cair et Cbox.

La figure 7A donne un autre mode de réalisation dans lequel l'empilement des couches 32,33 n'est effectif que sur trois côtés de l'élément piézorésistif 31. Dans cet exemple, la couche diélectrique 32 couvre à nouveau l'ensemble du contour de l'élément piézorésistif 31, tout en rappelant que cette situation n'est pas limitative. La couche électriquement conductrice 33 ne revêt que la face supérieure 34 de l'élément piézorésistif 31 et les flancs latéraux, à l'exclusion de la face inférieure de l'élément résistif 31.

Comparativement à la situation de la figure 6A, cela conduit à former un condensateur latéral droit et un condensateur latéral gauche. Ainsi, la schématisation des capacités électriques donnée à la figure 7B pour ce mode de réalisation diffère de la représentation de la figure 6B en ce que des capacités Cg et Cd sont ajoutées en parallèle, correspondant respectivement au condensateur gauche et au condensateur droit.

On comprend que le mode de réalisation de la figure 5A fournit le plus grand accroissement de capacité. Le cas de la figure 6A est le plus dégradé, et celui de la figure 7A est intermédiaire.

D'autres modes de réalisation entrent dans le cadre de la présente invention et notamment les suivants :
- l'empilement peut ne couvrir que l'un et/ou l'autre des flancs de l'élément résistif 31 de sorte à ne former que le condensateur gauche et/ou le condensateur droit ;
- l'empilement peut ne couvrir que la face inférieure de l'élément piézorésistif 31, située en regard de la face 13 du substrat.

La forme de la section transversale de l'empilement peut par ailleurs varier suivant la dimension en longueur de l'élément résistif 31. Par exemple, seule la face supérieure de l'élément piézorésistif peut être couverte par l'empilement sur une partie de la longueur de l'élément piézorésistif 31 alors que les flancs sont aussi couverts sur une autre partie de la longueur de cet élément. Tout autre d'arrangements, suivant la longueur de la jauge, de parties couvertes par l'empilement que cet exemple est possible. L'empilement peut être discontinu suivant cette longueur, même si cela n'est pas préféré pour favoriser l'augmentation de la capacité.

L'élément piézorésistif suspendu peut être obtenu de manière conventionnelle, et notamment en suivant l'exemple de la libération par gravure donnée précédemment. De préférence, l'empilement des couches 32,33 est formé postérieurement à la formation de l'élément piézorésistif 31 suspendu. Par exemple, la couche 32 peut être produite par une oxydation ou une nitruration superficielle du matériau de l'élément piézorésistif 31. Cela peut par exemple conduire à une couche de nitrure de silicium ou d'oxyde de silicium. À titre d'exemple, la dimension en épaisseur de la couche 32 peut être comprise entre 3 et 15 nanomètres, et par exemple être de 5 nm.

Dans ce contexte, la couche 32 recouvrira généralement l'intégralité du contour de l'élément piézorésistif 31.

La couche électriquement conductrice 33 peut par exemple être réalisée en silicium, de préférence dopée, ou encore en un matériau métallique suffisamment conducteur. Elle peut être produite par un dépôt suivant des techniques conventionnelles de déposition. Les parties sur lesquelles le dépôt n'est pas souhaité seront typiquement masquées auparavant. L'empilement n'est effectif que sur les parties de la couche 32 qui sont recouvertes par la couche 33.

L'épaisseur de la couche 32 n'est pas limitée, mais il peut être avantageux qu'elle reste inférieure à quelques dizaines de nanomètres, de préférence à moins de 20 nm. Elle peut par exemple être comprise entre 3 et 10 nanomètres, et notamment être égal à 5 nm.

Des valeurs similaires sont possibles pour la couche 33.

Dans un mode de réalisation, on cherche à faire en sorte que la construction de l'empilement ne modifie pas fondamentalement le comportement mécanique de la jauge. Notamment, on peut s'arranger pour que l'empilement procure un accroissement de rigidité de la jauge peu élevé relativement à la rigidité intrinsèque de l'élément piézorésistif 31. Dans ce contexte, par exemple, l'épaisseur de l'empilement peut, au global, être inférieure à 10 % de la plus grande dimension de la section de l'élément résistif (typiquement la largeur ou la longueur de la section).

Dans un exemple correspondant à une jauge 3 comprenant un élément piézorésistif parcourant l'ensemble de sa longueur, fixée à 2 µm, en ayant une section carrée d'élément 31 de 0,25 µmx 0,25 µm, et une épaisseur de couche diélectrique 32 de 5 nm, en considérant une capacité initiale de 40 aF, on pourrait multiplier la capacité finale d'un facteur de 266, 66 et 199 respectivement dans les cas des figures 5A, 6A et 7A.

Bien entendu, le gain en termes de bruit est d'autant plus important que l'élément résistif 31 est de dimensions élevées, dans la mesure où l'empilement 32,33 conduit à un condensateur de valeur d'autant plus importante que la surface qu'il recouvre est élevée.

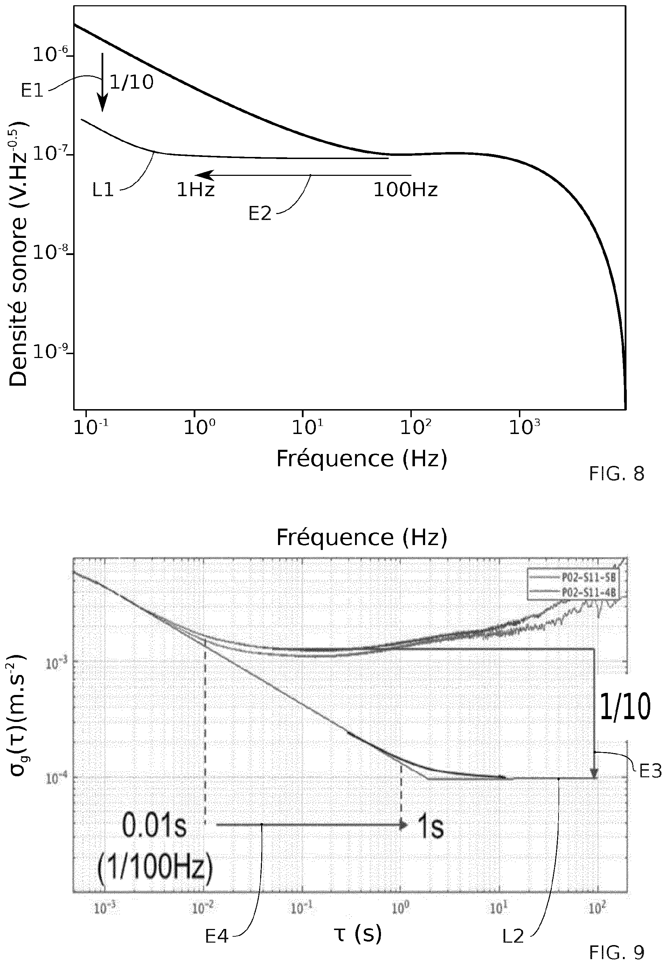

Les figures 8 et 9 traduisent l'effet très bénéfique de l'invention sur la réduction du bruit des capteurs piézorésistifs. Elles s'inscrivent dans un contexte de mise en oeuvre d'un dispositif du type accéléromètre correspondant à celui de la figure 6A (qui n'est pourtant pas le plus favorable), avec une jauge 3 comprenant un élément piézorésistif 31 parcourant l'ensemble de sa longueur, fixée à 2 µm, en ayant une section carrée d'élément 31 de 0,25 µmx 0,25 µm, et une épaisseur de couche diélectrique 32 de 5 nm, en considérant une capacité initiale de 40 aF.

Dans le cas de la figure 8, la densité spectrale du bruit est donnée en ordonnée en fonction de la fréquence donnée en abscisse avec des résultats de mesure correspondant à un accéléromètre classique, sans mise en oeuvre de l'invention. On y note l'impact du bruit en 1/f dans les basses fréquences, puis un palier à partir duquel c'est le bruit thermomécanique (bruit blanc) qui s'impose.

Sur cette figure, apparaît aussi une courbe L1 modélisant la modification du bruit grâce à l'invention avec, comme reflétée par la flèche E1, une réduction du bruit d'un facteur 10 en basse fréquence. La flèche E2 montre le décalage fréquentiel (ici de deux décades) de la partie en basse fréquence sur laquelle le bruit en 1/f est fort pénalisant, rendant ce type de bruit égale au bruit terme mécanique beaucoup plus tôt en fréquence.

La figure 9 présente une modélisation de l'invention en son effet sur la variance d'Allan. Comme pour la figure précédente, apparaissent des valeurs mesurées (correspondant à un capteur traditionnel) ainsi qu'une modélisation à la courbe L2 en mettant en oeuvre l'invention. Le point où le bruit basses fréquences est égal au bruit thermomécanique est décalé de 0,01 secondes à une seconde comme le montre la flèche E4, ce qui autorise des temps d'acquisition beaucoup plus élevée avec une résolution satisfaisante. La variance d'Allan est quant à elle diminuée d'un facteur 10 comme le montre la flèche E3 ; la résolution du capteur est donc augmentée d'un facteur 10.

Bien que s'appliquant à tout type de capteurs, ceux qui utilisent des jauges piézorésistives sur une bande passante commençant dans les basses fréquences, et potentiellement dès 0 Hz, tirent un grand profit de l'invention.

Il peut s'agir de capteurs de pression, de magnétomètres ou de microphones.

L'invention n'est pas limitée aux modes de réalisation précédemment décrits et s'étend à tous les modes de réalisation couverts par les revendications.

## Revendications

1. Dispositif de détection à transduction pour un capteur inertiel, comprenant un substrat (1), une masse (2) mobile par rapport au substrat (1), et une jauge (3) de contrainte suspendue au-dessus d'une face (13) du substrat (1), cette jauge (3) de contrainte comprenant un élément piézorésistif (31), dans lequel la jauge (3) comprend une première extrémité ancrée relativement au substrat (1) et une deuxième extrémité ancrée relativement à la masse (2), **caractérisé en ce qu'**au moins une partie de la surface de l'élément piézorésistif (31) est recouverte par un empilement comprenant, successivement depuis la surface de l'élément piézorésistif (31) une couche diélectrique (32) et une couche électriquement conductrice (33), cet empilement étant configuré tel que la capacité électrique formée par l'élément piézorésistif (31) et l'empilement soit d'une valeur supérieure à celle d'un condensateur formé entre l'élément piézorésistif (31) sans un tel empilement et le substrat (1).

2. Dispositif selon la revendication précédente, dans lequel la partie recouverte comprend une portion de surface de l'élément piézorésistif (31) opposée à la face du substrat (1).

3. Dispositif selon l'une quelconque des revendications précédentes, dans lequel la partie recouverte comprend une portion de surface de l'élément piézorésistif (31) en regard de la face du substrat (1).

4. Dispositif selon l'une quelconque des revendications précédentes, dans lequel l'élément piézorésistif (31) est une poutre.

5. Dispositif selon la revendication précédente, dans lequel la partie recouverte comprend une portion de surface située sur au moins un flanc de la poutre.

6. Dispositif selon l'une quelconque des revendications précédentes, dans lequel la partie recouverte s'étend suivant la totalité d'une dimension en longueur de l'élément piézorésistif (31).

7. Dispositif selon l'une quelconque des revendications précédentes, dans lequel la couche diélectrique (32) est en un matériau à base d'oxyde ou de nitrure de silicium.

8. Dispositif selon l'une quelconque des revendications précédentes, dans lequel la couche électriquement conductrice (33) est à base de silicium dopé ou d'un métal.

## Patentansprüche

1. Transduktionsdetektionsvorrichtung für einen Trägheitssensor, die ein Substrat (1), eine relativ zum Substrat (1) bewegliche Masse (2) und einen Dehnungsmessstreifen (3), der über einer Fläche (13) des Substrats (1) aufgehängt ist, umfasst, wobei der Dehnungsmessstreifen (3) ein piezoresistives Element (31) umfasst, bei dem der Messstreifen (3) ein erstes Ende, das relativ zum Substrat (1) verankert ist, und ein zweites Ende, das relativ zur Masse (2) verankert ist, umfasst, **dadurch gekennzeichnet, dass** mindestens ein Teil der Oberfläche des piezoresistiven Elements (31) von einem Stapel bedeckt ist, der sukzessive von der Oberfläche des piezoresistiven Elements (31) aus eine dielektrische Schicht (32) und eine elektrisch leitende Schicht (33) umfasst, wobei dieser Stapel so konfiguriert ist, dass die durch das piezoresistive Element (31) und den Stapel gebildete elektrische Kapazität einen größeren Wert aufweist als der eines Kondensators, der zwischen dem piezoresistiven Element (31) ohne einen solchen Stapel und dem Substrat (1) gebildet ist.

2. Vorrichtung nach dem vorhergehenden Anspruch, wobei der abgedeckte Teil einen Oberflächenabschnitt des piezoresistiven Elements (31) umfasst, der der Fläche des Substrats (1) entgegengesetzt ist.

3. Vorrichtung nach einem der vorhergehenden Ansprüche, wobei der abgedeckte Teil einen Oberflächenabschnitt des piezoresistiven Elements (31) umfasst, der der Fläche des Substrats (1) zugewandt ist.

4. Vorrichtung nach einem der vorhergehenden Ansprüche, wobei das piezoresistive Element (31) ein Balken ist.

5. Vorrichtung nach dem vorhergehenden Anspruch, wobei der abgedeckte Teil einen Oberflächenabschnitt umfasst, der sich auf mindestens einer Seite des Balkens befindet.

6. Vorrichtung nach einem der vorhergehenden Ansprüche, wobei der abgedeckte Teil sich entlang der gesamten Längenabmessung des piezoresistiven Elements (31) erstreckt.

7. Vorrichtung nach einem der vorhergehenden Ansprüche, wobei die dielektrische Schicht (32) aus einem Material auf Basis von Siliziumoxid oder -nitrid besteht.

8. Vorrichtung nach einem der vorhergehenden Ansprüche, wobei die elektrisch leitende Schicht (33) auf dotiertem Silizium oder einem Metall basiert.

## Claims

1. A transduction detection device for an inertial sensor, comprising a substrate (1), a mass (2) which is movable relative to the substrate (1), and a strain gauge (3) suspended above a face (13) of the substrate (1), this strain gauge (3) comprising a piezoresistive element (31), wherein the gauge (3) comprises a first end anchored relative to the substrate (1) and a second end anchored relative to the mass (2), **characterised in that** at least one part of the surface of the piezoresistive element (31) is covered by a stack comprising, successively from the surface of the piezoresistive element (31), a dielectric layer (32) and an electrically conductive layer (33), this stack being configured such that the electrical capacitance formed by the piezoresistive element (31) and the stack is of a value which is greater than that of a capacitor formed between the piezoresistive element (31) without such a stack and the substrate (1).

2. The device according to the preceding claim, wherein the covered part comprises a surface portion of the piezoresistive element (31) which is opposite to the face of the substrate (1).

3. The device according to any one of the preceding claims, wherein the covered part comprises a surface portion of the piezoresistive element (31) facing the face of the substrate (1).

4. The device according to any one of the preceding claims, wherein the piezoresistive element (31) is a beam.

5. The device according to the preceding claim, wherein the covered part comprises a surface portion located on at least one side of the beam.

6. The device according to any one of the preceding claims, wherein the covered part extends along the entire length dimension of the piezoresistive element (31).

7. The device according to any one of the preceding claims, wherein the dielectric layer (32) is made of a material based on silicon oxide or nitride.

8. The device according to any one of the preceding claims, wherein the electrically conductive layer (33) is based on doped silicon or a metal.
